# EUROPÄISCHE PATENTSCHRIFT

(11) **EP 0 440 835 B1**
(45) Veröffentlichungstag und Bekanntmachung des Hinweises auf die Patenterteilung: **20.09.1995**
(21) Anmeldenummer: 90102239.2
(22) Anmeldetag: 05.02.1990
(51) Int. Cl.: H02H 3/33, H03K 5/156

(54) **Differenzstromschutzschalter mit Transduktorschaltung mit Einrichtung zum Symmetrieren von Signalkurven**
Differential current circuit breaker with transducer with device for balancing pulse signals
Disjoncteur différentiel avec transducteur avec dispositif pour rendre symétriques des impulsions

(43) Veröffentlichungstag der Anmeldung: 14.08.1991
(73) Patentinhaber: SIEMENS AKTIENGESELLSCHAFT, 80333 München (DE)
(72) Erfinder: Harr, Dieter, Dipl.-Ing., D-8400 Regensburg (DE)

(56) Entgegenhaltungen:
- EP-A- 0 035 120
- EP-A- 0 167 079
- DE-A- 3 718 183
- FR-A- 2 430 680
- NEW ELECTRONICS.INCORPORATING ELECTRONICS TODAY. vol. 16, no. 7, April 1983, LONDON GB Seite 19 Y.Pang: "Pulse coincidence unit"
- "Integrierte Digitalbausteine, Kleines Praktikum", Karl Rei , 3. Auflage, 1974, Siemens AG, München Berlin
- "Das gro e Werkbuch Elektronik", Teil B, Ing. Dieter Nührmann, München 1989, Franzis Verlag GmbH München

## Beschreibung

Die Erfindung bezieht sich auf einen Differenzstromschutzschalter nach dem Transduktorprinzip, dessen von einem Frequenzgenerator beaufschlagte Sekundarwicklung auf einen gegebenenfalls komplexen Meßwiderstand arbeitet. Ein derartiger Differenzstromschutzschalter ist bekannt (EP-B1-0 167 079). Derartige Frequenzgeneratoren werden zum Vormagnetisieren des Summenstromwandlers des Differenzstromschutzschalters eingesetzt.

Der Erfindung liegt die Aufgabe zugrunde, einen Differenzstromschutzschalter zu entwickeln, dessen Auslöseempfindlichkeit bei positiven und bei negativen Fehlersignalen gleichhoch ist. Die Lösung der geschilderten Aufgabe erfolgt durch einen Differenzstromschutzschalter nach Patentanspruch. Dem Frequenzgenerator, der nach Art von Taktgeneratoren ausgeführt ist, wird eine Einrichtung zum Symmetrieren der abgegebenen Signalkurven nachgeschaltet. Der als Generatoranschluß dienende Systemeingang führt zu einem Frequenzteiler, dessen Teilungsfaktor in an sich bekannter Weise auf den reziproken Wert eines Vervielfachungsfaktors hinsichtlich einer gedachten Grundfrequenz des Systems bzw. des Frequenzgenerators eingestellt bzw. einstellbar ist. Der Ausgang des Frequenzteilers ist, gegebenenfalls unter Zwischenschaltung weiterer Elemente, zum Ausgang der Einrichtung geführt, wobei der Ausgang mit der Sekundärwicklung des Differenzstromschutzschalters verbunden ist. Zwischen dem Ausgang des Frequenzteilers und dem Ausgang der Einrichtung ist ein Kondensator geschaltet, wobei der als Meßwiderstand bezeichnete Widerstand, auf den die Einrichtung arbeitet, insgesamt kapazitiv ist.

Ein derartiger Differenzstromschutzschalter löst bei Wechselfehlerströmen und zusätzlich bei pulsierenden Fehlerströmen, aber auch bei Fehlerströmen mit glatten Gleichstromkomponenten und bei glatten Gleichstrom-Fehlerströmen aus. In Verbindung mit der Frequenzteilung erzielt man eine Symmetrierung hinsichtlich der Nulldurchgänge des Signals, wie es an sich bekannt ist. Hier wird jedoch das Auslöseverhalten bei positiven und bei negativen Fehlerströmen gleichgut. In Verbindung mit dem Trennkondensator erzielt man eine Symmetrierung hinsichtlich der Amplituden zur Nullinie und gleiches Auslöseverhalten bei positiven und bei negativen Fehlerströmen hinsichtlich unterschiedlicher Amplituden.

Durch gemeinsamen Einsatz der Frequenzteilung und der galvanischen Trennung erzielt man ein vollkommen gleiches Auslöseverhalten bei positiven und bei negativen Fehlerströmen hinsichtlich unterschiedlicher Nulldurchgänge oder Amplituden, seien sie durch die Fehlersignale vorgegeben oder durch unterschiedliche Toleranzen in den frequenzerzeugenden Elementen des Systems.

Der kapazitive Meßwiderstand bei einem Differenzstromschutzschalter nach dem Transduktorprinzip kann die galvanische Trennung übernehmen, so daß in der Einrichtung ein eigener Trennkondensator nicht erforderlich ist. Es wird dennoch eine Symmetrierung der Amplitude hinsichtlich der Nullinie erzielt.

Nach einem vorteilhaften Ausführungsbeispiel wird der Frequenzteiler der Einrichtung durch einen D-Flip-Flop realisiert. Insbesondere eignet sich ein flankengesteuerter D-Flip-Flop.

Die Erfindung soll nun anhand von in der Zeichnung grob schematisch wiedergegebenen Ausführungsbeispielen näher erläutert werden:

In FIG 1 ist eine Einrichtung zum Symmetrieren von Signalkurven, eingesetzt bei einem Differenzstromschutzschalter, veranschaulicht.

In FIG 2 ist eine Ausgestaltung der Einrichtung nach Art eines Blockschaltbildes wiedergegeben.

In FIG 3 ist eine Weiterbildung der Einrichtung in der Darstellungsweise nach FIG 2 wiedergegeben.

In FIG 4 ist eine weitere Weiterbildung der Einrichtung in der Darstellungsweise nach FIG 2 wiedergegeben.

In den Figuren 5 bis 8 sind Diagramme dargestellt, in denen der Signalverlauf und die Funktionsweise der Einrichtung veranschaulicht ist.

In FIG 9 ist ein Ausführungsbeispiel für den Frequenzvervielfacher der Einrichtung wiedergegeben.

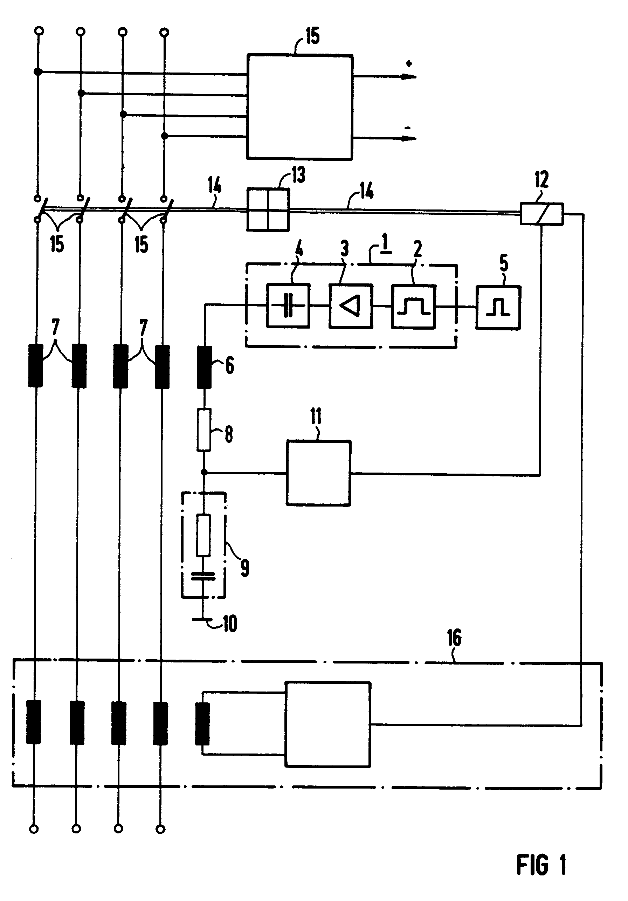

Die Einrichtung 1 zum Symmetrieren von Signalkurven besteht im Ausführungsbeispiel nach FIG 1 zunächst aus einem Frequenzteiler 2, um die Signalkurve hinsichtlich der Nulldurchgänge zu symmetrieren. Ein Verstärker 3 wird günstigerweise zum Verstärken der in ihrer Frequenz geteilten Signalkurve eingesetzt. Nach einer Weiterbildung nach FIG 1 ist in der Einrichtung ein Kondensator 4 nachgeschaltet, der dafür ausgelegt ist, die Einrichtung gegen den zweiten Pol, im Ausführungsbeispiel Erde, galvanisch zu trennen. Die Einrichtung 1 wird von einem Frequenzgenerator 5 gespeist, der als Taktgenerator zur Erzeugung von Rechteckkurven ausgelegt ist.

Der Frequenzteiler 2 weist einen Teilungsfaktor auf, der auf den reziproken Wert eines Vervielfachungsfaktors, im Ausführungsbeispiel des Frequenzgenerators 5, einstellbar ist. Dieser Vervielfachungsfaktor liegt gedanklich dem abgegebenen Signal des Frequenzgenerators 5 hinsichtlich einer gedachten Grundfrequenz zugrunde. Im einfachsten Fall stellt man den Frequenzgenerator auf eine doppelte Frequenz einer gedachten Grundfrequenz ein und teilt im Frequenzteiler durch zwei. In der Einrichtung können gegebenenfalls weitere Elemente zwischengeschaltet sein, im Ausführungsbeispiel ein Verstärker 3.

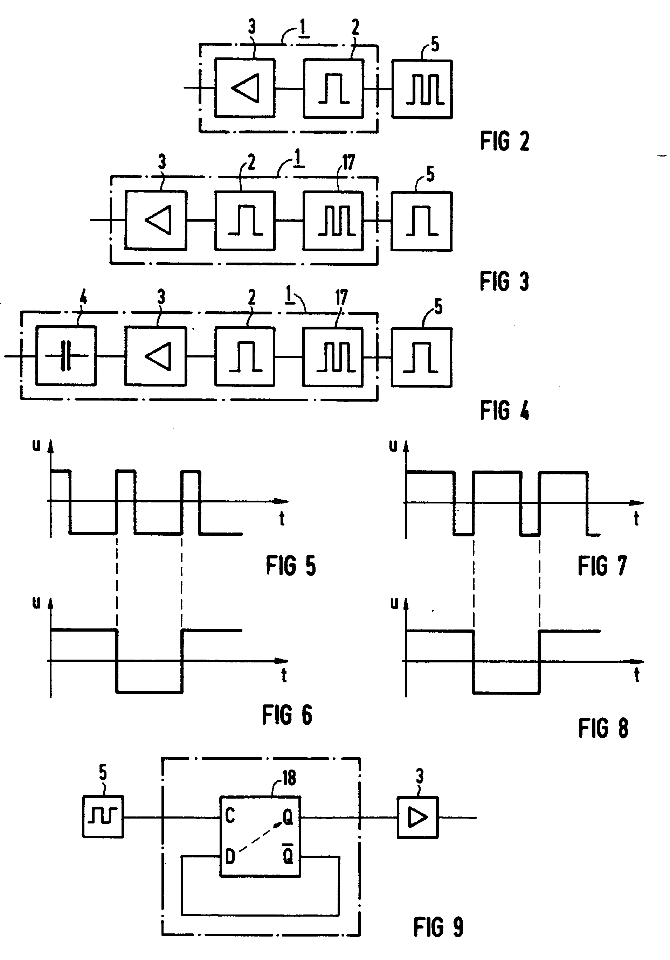

Der Kondensator 4 zur galvanischen Trennung bewirkt eine Symmetrierung der Amplituden zur Nullinie, im Ausführungsbeispiel nach FIG 1 ist es die Erde, wodurch ein gleiches Auslöseverhalten bei positiven und bei negativen Fehlerströmen trotz abweichender Amplituden der Taktfrequenz erzielt wird. Diese Symmetrierung ergänzt die Symmetrierung durch den Frequenzteiler 2, der die Signalkurve hinsichtlich ihrer Nulldurchgänge symmetriert. Die Wirkungsweise im einzelnen soll anhand der Figuren 5 bis 8 später im einzelnen erläutert werden:

Die Einrichtung 1 ist nach FIG 1 bei einem Differenzstromschutzschalter mit Transduktorschaltung eingesetzt und dient dazu, dessen Vormagnetisierung zu symmetrieren. Ein derartiger Differenzstromschutzschalter an sich ist in EP-B1-0 167 079 im einzelnen erläutert.

Die Einrichtung 1 ist an der Sekundärwicklung 6 eines Summenstromwandlers 7 angeschlossen und führt den Summenstromwandler eine Vormagnetisierung durch den Frequenzgenerator 5 zu. Der Sekundärwicklung 6 ist ein Dämpfungswiderstand 8 und ein Meßwiderstand 9 gegen Erde 10 nachgeschaltet. Eine Auswerteschaltung 11 steht mit einer Auslöseeinrichtung 12 in Verbindung. Die Auslöseeinrichtung 12 steht ihrerseits mit einem Schaltschloß 13 in Eingriffverbindung 14. Das Schaltschloß 13 wirkt über die Wirkverbindung 14 auf Schaltkontakte 15 in zu überwachenden Leitern ein. Der Summenstromwandler 7 kann als Transduktorschaltung mit Vormagnetisierung durch den Frequenzgenerator 5 verstanden werden.

Bei einer Transduktorschaltung wird die Sekundärseite durch eine angelegte, hochfrequente Wechselspannung bis nahe an die Sättigungsgrenze wechselmagnetisiert. In Serienschaltung mit der Sekundärwicklung ist der Meßwiderstand 9 angeordnet, wo Signale für eine Auswerteschaltung abgegriffen werden können. Wenn durch die Primärwicklung ein Strom fließt, wird in der Sekundärwicklung ein Strom induziert, der dort dem Wechselmagnetisierungsstrom überlagert wird. Dadurch wird die Sättigungsgrenze überschritten und der induktive Widerstand der Sekundärwicklung wird kleiner. Als Folge davon wird die Spannungsamplitude am Meßwiderstand 9 größer. In der Auswerteschaltung wird die Spannung am Meßwiderstand mit einer zuvor eingestellten Schwellenspannung verglichen und bei Überschreiten der Schwellenspannung die Auslöseeinrichtung aktiviert, die dann die zu überwachende Leitung unterbricht. Der geschilderte Differenzstromschutzschalter nach FIG 1 erhält die Bordnetzversorgung seiner elektronischen Bauelemente über ein Netzteil 15 aus der Netzspannung der zu überwachenden Leiter.

Im Ausführungsbeispiel nach FIG 1 arbeitet der Differenzstromschutzschalter mit einem Fehlerstromschutzschalter 16 zusammen, der parallel zum Differenzstromschutzschalter auf die Auslöseeinrichtung 12 elektrisch einwirkt. Der Fehlerstromschutzschalter stellt seine Funktionsweise unabhängig von der Netzspannung sicher. Er wirkt dadurch zum Differenzstromschutzschalter redundant. Der Fehlerstromschutzschalter löst in einer üblichen Grundausführung bei Wechselfehlerströmen und in einer heute in der Regel geforderten Ausführung auch bei pulsierenden Fehlerströmen aus. Der Differenzstromschutzschalter löst in der Ausführung nach dem Transduktorprinzip bei sämtlichen Fehlerstromarten, also auch bei glattem Gleichfehlerstrom aus.

In FIG 2 ist eine Einrichtung zum Symmetrieren von Signalkurven in einer einfachen Ausführung veranschaulicht. Der Frequenzgenerator 5 ist auf die doppelte Frequenz einer gedachten Grundfrequenz eingestellt und die Einrichtung 1 besteht aus einem Frequenzteiler 2, was im Prinzip für eine Symmetrierung hinsichtlich der Nulldurchgänge der Signalkurve ausreicht. Im Ausführungsbeispiel ist noch ein Verstärker 3 untergebracht. Nach FIG 3 weist die Einrichtung 1 einen Frequenzvervielfacher 17, einen Frequenzteiler 2 und einen Verstärker 3 auf. Ein Frequenzvervielfacher 17 hat den Vorteil, daß man in der Wahl einer Vervielfachungsfrequenz von den Einstellmöglichkeiten des Frequenzgenerators frei ist.

In der Ausführung nach FIG 4 ist zusätzlich zur Ausführung nach FIG 3 noch ein Kondensator 4 zur galvanischen Trennung in der Einrichtung 1 angeordnet. Der Kondensator 4 zur galvanischen Trennung vom zweiten Anschluß der Einrichtung 1 ermöglicht die Symmetrierung der Signalkurve hinsichtlich unterschiedlicher Signalamplituden.

In den Diagrammen nach den Figuren 5 bis 8 ist auf der Abszisse jeweils die Zeit und auf der Ordinate die Spannung aufgetragen. In FIG 5 wird ein Beispiel für eine hinsichtlich der Nulldurchgänge nicht symmetrische Signalkurve nach der Frequenzvervielfachung übertrieben wiedergegeben. In FIG 6, die mit FIG 5 zusammenspielt ist die Wirkung der Frequenzteilung zu einer Signalkurve nach FIG 5 veranschaulicht. Die Frequenzteilung wird durch den Signalnulldurchgang getriggert und eliminiert die Unterschiede der positiven und negativen Halbwelle der Signalkurve nach FIG 5 hinsichtlich der Mittellinie, die auf Nullpotential oder Erdpotential verstanden werden kann. In FIG 7 ist eine nicht symmetrierte Signalkurve wieder übertrieben unsymmetrisch hinsichtlich der Nulldurchgänge und als Gegenbeispiel zu FIG 5 veranschaulicht. Nach FIG 7 sind die positiven Halbwellen übertrieben lang und die negativen Halbwellen übertrieben kurz. In FIG 8 ist wieder die Wirkung der Frequenzteilung veranschaulicht, wobei FIG 8 mit FIG 7 zusammenspielt. Die Frequenzteilung ist wieder durch die Nulldurchgänge nach FIG 7 getriggert. Die Zusammenschau nach FIG 5 und 6 sowie nach FIG 7 und 8 ist im Maßstab 1:1 zu verstehen.

In FIG 9 ist ein Ausführungsbeispiel für einen Frequenzteiler veranschaulicht, der als D-Flip-Flop, insbesondere als flankengesteuerter D-Flip-Flop, ausgeführt ist. Der Flip-Flop-Baustein 18 des Frequenzteilers 2 weist die Anschlüsse C= Clock, D=Eingang, Q=Ausgang und Q̅=invertierender Ausgang auf. Die Anschlüsse D und Q̅ sind miteinander leitend verbunden. Die Wirkungsweise eines derartigen D-Flip-Flops ist hinlänglich bekannt.

## Patentansprüche

1. Differenzstromschutzschalter nach dem Transduktorprinzip, dessen von einem Frequenzgenerator (5) beaufschlagte Sekundärwicklung (6) auf einen gegebenenfalls komplexen Meßwiderstand (9) arbeitet,
**dadurch gekennzeichnet**, daß der Frequenzgenerator (5) nach Art von Taktgeneratoren ausgeführt ist, wobei eine Einrichtung (1) zum Symmetrieren der abgegebenen Signalkurven nachgeschaltet ist, wobei in der Einrichtung ihr als Generatoranschluß dienender Systemeingang zu einem Frequenzteiler (2) führt, dessen Teilungsfaktor in an sich bekannter Weise auf den reziproken Wert eines Vervielfachungsfaktors hinsichtlich einer gedachten Grundfrequenz des Systems bzw. des Frequenzgenerators (5) eingestellt bzw. einstellbar ist, wobei der Ausgang des Frequenzteilers (2), gegebenenfalls unter Zwischenschaltung weiterer Elemente (3), zum Ausgang der Einrichtung (1) führt, der mit der Sekundärwicklung (6) des Differenzstromschutzschalters verbunden ist, wobei zwischen dem Ausgang des Frequenzteilers (2) und dem Ausgang der Einrichtung (1) ein Kondensator (4) geschaltet ist, und daß der Meßwiderstand (9) insgesamt kapazitiv ist.

## Claims

1. A differential current circuit breaker in accordance with the transductor principle, the secondary winding (6) of which, which is fed by a frequency generator (5), acts on an optionally complex shunt (9), characterised in that the frequency generator (5) is designed in the manner of clock generators, where a device (1) for balancing the emitted signal curves follows, where in the device its system input, which serves as generator terminal, leads to a frequency divider (2), the division factor of which is set or can be set in a manner known per se at the reciprocal value of a multiplication factor in respect of an imaginary fundamental frequency of the system or the frequency generator (5), where the output of the frequency divider (2) leads, optionally with the interposition of further elements (3), to the output of the device (1) which is connected to the secondary winding (6) of the differential current circuit breaker, where a capacitor (4) is connected between the output of the frequency divider (2) and the output of the device (1), and that the shunt (9) is overall capacitive.

## Revendications

1. Disjoncteur différentiel fonctionnant selon le principe du transducteur et dont l'enroulement secondaire (6), qui est chargé par un générateur de fréquence (5), travaille avec une résistance de mesure éventuellement complexe (9), caractérisé par le fait que le générateur de fréquence (5) est réalisé à la manière de générateurs de cadence, un dispositif (1) servant à rendre symétriques les courbes délivrées du signal étant branché en aval, tandis que, dans le dispositif, son entrée dans le système, utilisée comme borne du générateur, est reliée à un diviseur de fréquence (2), dont le rapport de division est réglé ou peut être réglé de façon connue en soi sur l'inverse d'un facteur multiplicatif en rapport avec une fréquence de base imaginaire du système ou du générateur de fréquence (5), et la sortie du diviseur de fréquence (2) étant reliée, éventuellement moyennant le montage intercalaire d'autres éléments (3), à la sortie du dispositif (1), qui est reliée à l'enroulement secondaire (6) du disjoncteur différentiel, un condensateur (4) étant branché entre la sortie du diviseur de fréquence (2) et la sortie du dispositif (1), et que la résistance de mesure (9) est globalement capacitive.
